# EUROPEAN PATENT SPECIFICATION

(11) **EP 2 117 037 B1**
(45) Date of publication and mention of the grant of the patent: **19.12.2012**
(21) Application number: 08711851.9
(22) Date of filing: 22.02.2008
(51) Int. Cl.: H01L 23/532, H01L 21/768, H01L 21/312

(54) **INTERLAYER INSULATION FILM, AND METHODS FOR PRODUCTION THEREOF**
ZWISCHENSCHICHTISOLATIONSFILM UND HERSTELLUNGSVERFAHREN DAFÜR
FILM D'ISOLATION INTERCOUCHE, ET PROCEDES POUR LEUR FABRICATION

(30) Priority: 28.02.2007 JP 2007050236
(43) Date of publication of application: 11.11.2009
(73) Proprietor: Zeon Corporation, Chiyoda-ku Tokyo 100-8246 (JP)
(72) Inventor: OHMI, Tadahiro, Sendai-shi Miyagi 980-8577 (JP); YASUDA, Seiji, Sendai-shi Miyagi 980-8577 (JP); INOKUCHI, Atsutoshi, Nirasaki-shi Yamanashi 407-0192 (JP); MATSUOKA, Takaaki, Tokyo 107-6325 (JP); KAWAMURA, Kohei, Hillsboro, Oregon 97124 (US); NAKAMURA, Masahiro, Tokyo 100-8246 (JP)
(74) Representative: Albrecht, Thomas
(86) International application number: PCT/JP2008/053083
(87) International publication number: WO 2008/105344

(56) References cited:
- EP-A2- 0 701 283
- WO-A1-2006/077802
- JP-A- 10 107 023
- JP-A- 2005 524 983
- JP-A- 2006 286 932
- US-A1- 2010 032 844
- "Nitrogen doped fluorinated amorphous carbon thin films grown by plasma enhanced chemical vapor deposition for low dielectric constant interlayer dielectrics" APPLIED PHYSICS LETTERS, AIP, AMERICAN INSTITUTE OF PHYSICS, MELVILLE, NY, US LNKD- DOI:10.1063/1.115761, vol. 68, no. 25, 17 June 1996 (1996-06-17) , pages 3656-3658, XP012015549 ISSN: 0003-6951

## Description

### Technical Field

This invention relates to a multilayer interconnect structure formed on a substrate or a board, such as a semiconductor element substrate or semiconductor-chip mounting board or a wiring board, and, in particular, to a structure of an interlayer insulation film.

### Background Art

Conventionally, an interlayer insulation film is formed for insulation between interconnect layers included in a multilayer interconnect structure formed on a semiconductor substrate or the like.

In such a multilayer interconnect structure, a problem of signal delay due to the parasitic capacitance between interconnections and the interconnect resistance has become unignorable, and various kinds of structures have been proposed in order to respond to demands of using an interlayer insulation film of a low dielectric constant (Low-k) (See Patent Document 1).

Patent Document 1 proposes the use of a fluorocarbon (CF) film as an interlayer insulation film. The film is formed by using a plasma processing apparatus which uses He, Ne, Ar, Xe, or Kr gas as a gas for generating plasma. In the plasma processing apparatus, use is made of a fluorocarbon gas (hereinafter referred to as a CFₓ gas, which is, for example, C₅F₈ gas). In addition, in Patent Document 1, in order to adjust the electron density of the generated plasma, N₂, H₂, and/or NH₃ are/is used in combination with a rare gas for dilution thereof, whereby satisfactory adhesion and a satisfactory shape of the formed film are obtained.

Patent Document 1: JP-A-2002-220668
Nitrogen doped fluorinated amorphous carbon thin films grown by plasma enhanced chemical vapor deposition for low dielectric constant interlayer dielectrics are described in Applied Physics Letters, vol. 68, No. 25, pages 3656-3658. More specifically, there is described an interlayer insulation film formed by laminating a hydrocarbon layer and a fluorocarbon layer containing N atoms, wherein the hydrocarbon layer contains H atoms and C atoms.
European patent application EP 0701283 A2 describes a semiconductor device in which interlayer insulative layers are composed of an amorphous carbon film. The amorphous carbon film may include fluorine (F) therein. The documents further describes a method of fabricating a semiconductor device including an interlayer insulative layer composed of an amorphous carbon film including fluorine (F), the method comprising the step of carrying out plasma-enhanced chemical vapor deposition (PCVD) using a mixture gas including (a) at least one of CF₄, C₂F₆, C₃F₈, C₄F₈ and CHF₃, and (b) at least one of N₂, NO, NO₂, NH₃ and NF₃.
US patent application US 2010/032844 describes a wiring structure of a semiconductor device or the like which includes an interlayer insulating film having a fluorocarbon film formed on an underlayer, and a conductor buried in the interlayer insulating film. The fluorocarbon film contains nitrogen and is low in dielectric constant, excellent in reproducibility and stable.

### Disclosure of the Invention

### Problem to be Solved by the Invention

As an exemplary structure of an interlayer insulation film having a low dielectric constant, a proposal is made about obtaining an interlayer insulation film which has a very low dielectric constant and which includes a combination of a fluorocarbon film (hereinafter referred to as a CF film) having a specific dielectric constant k of 2.0 to 2.2 and a hydrocarbon film (hereinafter referred to as a CH film) having a specific dielectric constant k of about 3.0 as a barrier layer of the CF film.

Such an interlayer insulation film can show satisfactory insulation film characteristics, but, in order to further improve the characteristics of the device, it is still necessary to lower the dielectric constant. However, it has been found out that, if the specific dielectric constants of the respective films are attempted to be further lowered, a problem is caused to occur such that using the CF film brings about a reduction of a withstand voltage and, as a result, about an increase of a leak current. In addition, using the CH film brings about shrinkage of the film (which is shrunk in volume by as much as about 6 %) due to decomposition of a film framework of the CH film during thermal annealing.

Accordingly, it is an object of this invention to provide an interlayer insulation film which has a low dielectric constant and is stable and in which occurrence of leak current and film shrinkage due to thermal annealing are suppressed.

It is another object of this invention to provide a method of producing or manufacturing the interlayer insulation film.

### Means to Solve the Problem

As a result of energetic study to solve the above-mentioned problem, the inventors of this invention found that, by containing N atoms in a CF film, the specific dielectric constant thereof is lowered as compared with that in a conventional case and the withstand voltage is improved to suppress occurrence of leak current, that, by containing Si atoms in a CH film, the specific dielectric constant thereof is lowered as compared with that in a conventional case to suppress film shrinkage due to thermal annealing, and that, by laminating those films, an interlayer insulation film having desired characteristics is obtained, thereby completing this invention.

Namely, according to this invention, there is provided an interlayer insulation film formed by laminating a hydrocarbon layer containing 2 to 10 atom% of Si atoms and a fluorocarbon layer containing 0.5 to 6 atom% of N atoms,
wherein the hydrocarbon layer contains H atoms and C atoms with a ratio of a number of the H atoms to a number of the C atoms (H/C) being from 0.8 to 1.2 and
wherein the fluorocarbon layer contains F atoms and C atoms with a ratio of a number of the F atoms to a number of the C atoms (F/C) being from 0.8 to 1.1.

In addition, according to this invention, there is provided the interlayer insulation film mentioned above, wherein the fluorocarbon layer containing N atoms is laminated on the hydrocarbon layer containing Si atoms.

Further, according to this invention, there is provided the interlayer insulation film mentioned, wherein a hydrocarbon layer containing Si atoms is further laminated on the fluorocarbon layer containing N atoms.

Additionally, according to this invention, there is provided any one of the above-mentioned interlayer insulation films, wherein each hydrocarbon layer containing Si atoms has a specific dielectric constant k1 of 2.8 to 3.0.

According to this invention, there is provided any one of the interlayer insulation films mentioned above, wherein the fluorocarbon layer containing N atoms has a specific dielectric constant k2 of 1.5 to 2.2.

According to this invention, there is provided any one of the interlayer insulation films mentioned above, wherein each hydrocarbon layer containing Si atoms has a thickness of 10 to 50 nm.

According to this invention, there is provided any one of the interlayer insulation films mentioned above, wherein the fluorocarbon layer containing N atoms has a thickness of 50 to 500 nm.

According to this invention, there is provided a method of manufacturing any one of the interlayer insulation films mentioned above, wherein each hydrocarbon layer containing Si atoms is formed by CVD using at least one type of gas containing C atoms and H atoms and a gas containing Si atoms in plasma, the plasma being generated using at least one gas selected from the group consisting of Ar gas, Xe gas, and Kr gas.

According to this invention, there is provided a method of manufacturing any one of the interlayer insulation films mentioned above, wherein the fluorocarbon layer containing N atoms is formed by CVD using at least one type of gas containing C atoms and F atoms and a gas containing N atoms in plasma, the plasma being generated using at least one gas selected from the group consisting of Ar gas, Xe gas, and Kr gas.

There is also described herein a film forming method of forming an interlayer insulation film, comprising laminating a hydrocarbon layer containing Si atoms and a fluorocarbon layer containing N atoms, wherein the hydrocarbon layer contains H atoms and C atoms with a ratio of a number of the H atoms to a number of the C atoms (H/C) being from 0.8 to 1.2.

There is also described herein the film forming method, wherein the fluorocarbon layer containing N atoms is laminated on the hydrocarbon layer containing Si atoms.

There is also described herein the film forming method, wherein a hydrocarbon layer containing Si atoms is further laminated on the fluorocarbon layer containing N atoms.

There is also described herein any one of the film forming methods mentioned above, wherein each hydrocarbon layer containing Si atoms has a specific dielectric constant k1 of 2.8 to 3.0.

There is also described herein any one of the film forming methods mentioned above, wherein each hydrocarbon layer containing Si atoms contains 2 to 10 atom% of Si atoms.

There is also described herein any one of the film forming methods mentioned above, wherein the fluorocarbon layer containing N atoms has a specific dielectric constant k2 of 1.5 to 2.2.

There is also described herein any one of the film forming methods mentioned above, wherein the fluorocarbon layer containing N atoms contains F atoms and C atoms with a ratio of a number of the F atoms to a number of the C atoms (F/C) being from 0.8 to 1:1, and contains 0.5 to 6 atom% of N atoms.

There is also described herein any one of the film forming methods mentioned above, wherein each hydrocarbon layer containing Si atoms has a thickness of 10 to 50 nm.

There is also described herein any one of the film forming methods mentioned above, wherein the fluorocarbon layer containing N atoms has a thickness of 50 to 500 nm.

According to this invention, there is provided any one of the film forming methods mentioned above, wherein each hydrocarbon layer containing Si atoms is formed by CVD using at least one type of gas containing C atoms and H atoms and a gas containing Si atoms in plasma, the plasma being generated using at least one gas selected from the group consisting of Ar gas, Xe gas, and Kr gas.

According to this invention, there is provided any one of the film forming methods mentioned above, wherein the fluorocarbon layer containing N atoms is formed by CVD using at least one type of gas containing C atoms and F atoms and a gas containing N atoms in plasma, the plasma being generated using at least one gas selected from the group consisting of Ar gas, Xe gas, and Kr gas.

There may be obtained an interconnect structure formed by forming the above-mentioned interlayer insulation film.This interconnect structure does not form part of the invention.

There may be obtained the above-mentioned interconnect structure, wherein the fluorocarbon layer containing N atoms is laminated on the hydrocarbon layer containing Si atoms.This interconnect structure does not form part of the invention.

There may be obtained the above-mentioned interconnect structure, wherein a hydrocarbon layer containing Si atoms is further laminated on the fluorocarbon layer containing N atoms.This interconnect structure does not form part of the invention.

There may be obtained any one of the above-mentioned interconnect structure, wherein the hydrocarbon layer containing Si atoms has a specific dielectric constant k1 of 2.8 to 3.0. This interconnect structure does not form part of the invention.This interconnect structure does not form part of the invention.

There may be obtained any one of the above-mentioned interconnect structure, wherein the fluorocarbon layer containing N atoms has a specific dielectric constant k2 of 1.5 to 2.2. This interconnect structure does not form part of the invention.

There may be obtained any one of the above-mentioned interconnect structure, wherein each hydrocarbon layer containing Si atoms has a thickness of 10 to 50 nm.This interconnect structure does not form part of the invention.

There may be obtained any one of the above-mentioned interconnect structure, wherein the fluorocarbon layer containing N atoms has a thickness of 50 to 500 nm. This interconnect structure does not form part of the invention.

There may be obtained any one of the above-mentioned interconnect structure, wherein each hydrocarbon layer containing Si atoms is formed by CVD using at least one type of gas containing C atoms and H atoms and a gas containing Si atoms in plasma, the plasma being generated using at least one gas selected from the group consisting of Ar gas, Xe gas, and Kr gas.This interconnect structure does not form part of the invention.

There may be obtained any one of the above-mentioned interconnect structure, wherein the fluorocarbon layer containing N atoms is formed by CVD using at least one type of gas containing C atoms and F atoms and a gas containing N atoms in plasma, the plasma being generated using at least one gas selected from the group consisting of Ar gas, Xe gas, and Kr gas. This interconnect structure does not form part of the invention.

### Effect of the Invention

According to this invention, there is provided an interlayer insulation film, which can be used for a semiconductor device and which has a low dielectric constant and is stable.

Further, not being part of the invention, there may be obtained an interconnect structure with an interlayer insulation film of a low dielectric constant and a method of manufacturing the same, wherein the interlayer insulation film has an improved withstand voltage and a reduced leak current and, in addition, a reduced amount of shrinkage in volume.

### Brief Description of the Drawing

Fig. 1 is a view illustrating an interconnect structure according to an embodiment of this invention.
Fig. 2 is a schematic sectional view illustrating a plasma processing apparatus.
Fig. 3 is a graph illustrating change in value of a specific dielectric constant k2 by addition of N atoms in a CF film containing N atoms according to the embodiment of this invention.
Fig. 4 is a graph illustrating change in an insulation withstand voltage by addition of N atoms in the CF film containing N atoms according to the embodiment of this invention.
Fig. 5 is a graph illustrating change in leak current density by addition of N atoms in the CF film containing N atoms according to the embodiment of this invention.
Fig. 6 is a graph illustrating change in film remaining or shrinkage rate by addition of N atoms in the CF film containing N atoms according to the embodiment of this invention.
Fig. 7 is a graph illustrating change in value of a specific dielectric constant k1 and change in film shrinkage rate due to thermal annealing by addition of Si atoms in a CH film containing Si atoms as a barrier layer according to the embodiment of this invention.

### Description of Symbols

- 1: hydrocarbon layer containing Si atoms
- 2: fluorocarbon layer containing N atoms
- 3: hydrocarbon layer containing Si atoms
- 4: via hole
- 5: groove
- 6: electrode or wiring
- 7: wiring conductor (Cu)
- 10: interconnect structure
- 12: waveguide
- 13: gas introduction pipe
- 14: silicon wafer
- 21: radial line slot antenna (RLSA)
- 22: lower shower plate
- 23: upper shower plate
- 26: gas introduction pipe
- 31: process chamber

### Best Mode for Embodying the Invention

An embodiment of this invention is described in the following with reference to the drawings.

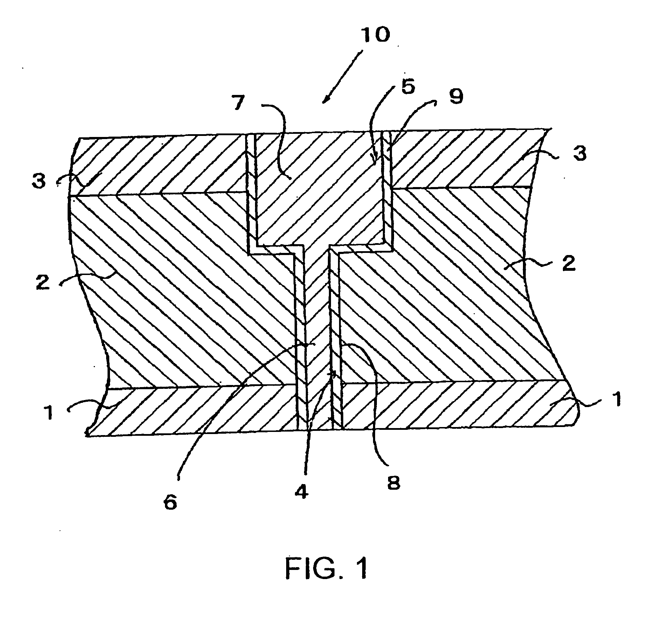

Fig. 1 is a sectional view illustrating an interconnect structure not being part of the invention. As illustrated in Fig. 1, a semiconductor device has a multilayer interconnect structure (only one connecting portion between interconnect layers is illustrated) 10 provided on a semiconductor substrate (not shown) having a number of semiconductor elements formed thereon. The illustrated multilayer interconnect structure 10 forms an interlayer insulation film and has a first hydrocarbon layer 1 containing Si atoms which is a hydrocarbon film (hereinafter referred to as a CH film) as a barrier cap layer, a fluorocarbon layer 2 containing N atoms as a fluorocarbon film (hereinafter referred to as a CF film) laminated on the first hydrocarbon layer 1, and further, a second hydrocarbon layer 3 containing Si atoms, which is a CH film as a barrier layer and which is laminated on the fluorocarbon layer 2.

Here, the first and second hydrocarbon layers 1 and 3 contain H atoms and C atoms at the ratio of the number of the H atoms to the number of the C atoms (H/C) which falls within a range between 0.8 and1.2. On the other hand, the fluorocarbon layer 2 contains F atoms and C atoms at the ratio of the number of the F atoms to the number of the C atoms (F/C) which falls within a range between 0.8 and 1.1.

The ratios of the respective atoms in the films (or layers) herein described may be determined by X-ray photoelectron spectroscopy (XPS) or Rutherford Backscattering Spectrometry /Hydrogen Forward Spectrometry (RBS/HFS).

A via hole 4 is provided which is passed through the first hydrocarbon layer 1 and a lower part of the fluorocarbon layer 2. On an inner wall of the via hole 4, a film made of a fluoride of nickel, preferably, nickel (II) fluoride (namely, nickel difluoride) (expressed as NiF₂), is formed as a diffusion preventing layer 8 for Cu wiring 6 by forming a nickel film by PVD and then fluorinating the film, or by directly forming the film made of the fluoride of nickel by MOCVD.

An electrode or wiring 6 of Cu is formed in the via hole 4. A groove 5 is formed so as to allow the remaining part (upper part) of the fluorocarbon layer 2 and the hydrocarbon layer 3 to pass therethrough. A film of a fluoride made of nickel, preferably nickel (II) fluoride (expressed as NiF₂), is similarly formed on an inner wall of the groove as a diffusion preventing layer 9 for Cu wiring 7. A wiring conductor 7 made of Cu is embedded in the groove 5.

From the viewpoint of drastically lowering the dielectric constant of the interlayer insulation film as a whole compared with that of a conventional interlayer insulation film, each specific dielectric constant k1 of the hydrocarbon layers containing Si atoms which form the first hydrocarbon layer 1 and the second hydrocarbon layer 3 is preferably 2.8 to 3.0. From a similar viewpoint, a specific dielectric constant k2 of the fluorocarbon layer containing N atoms which forms the fluorocarbon layer 2 is preferably 1.5 to 2.2.

The specific dielectric constants of the films (or layers) herein described may be measured by a mercury probe method or the like.

The thicknesses of the hydrocarbon layers containing Si atoms which form the first and second hydrocarbon layers 1 and 3 are, though not particularly limited, usually 10 to 50 nm, while the thickness of the fluorocarbon layer containing N atoms which forms the fluorocarbon layer 2 is, though not particularly limited, usually 50 to 500 nm.

In Fig. 1, the illustrated interlayer insulation film is formed by laminating the CH films and the CF film, i.e., the first hydrocarbon layer 1 containing Si atoms, the fluorocarbon layer 2 containing N atoms, and the second hydrocarbon layer 3 containing Si atoms in the stated order. However, the order of lamination of the CH film(s) and the CF film(s) and the number of the laminated CH film(s) and the CF film(s) according to this invention are not specifically limited as long as the desired effect of this invention is not prevented and another film made of an arbitrary material may be inserted between a CH film and a CF film therein.

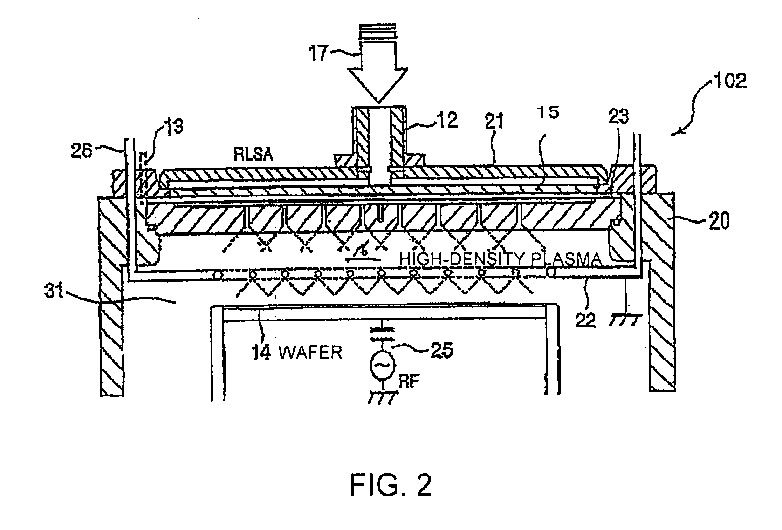

Fig. 2 is a schematic sectional view illustrating a plasma processing apparatus not being part of the invention. Referring to Fig. 2, a microwave 17 is supplied through a waveguide 12 to a radial line slot antenna (RLSA) 21 disposed above a container main body 20 of the plasma processing apparatus 102 via an insulator plate 15. Thereafter, the microwave 17 is transmitted from the radial line slot antenna (RLSA) 21 through the insulator plate 15 to an upper shower plate 23 located under the RLSA 21 and is emitted into a plasma generating region 16. As a plasma excitation gas for exciting plasma, usually, at least one rare gas selected from the group consisting of Ar gas, Xe gas, and Kr gas is uniformly ejected into the plasma generating region 16 from the upper shower plate 23 via a gas introduction pipe 13, and plasma is excited by the microwave emitted thereinto.

A lower shower plate 22 is disposed in a diffusion plasma region of the plasma processing apparatus 102.

Here, when the rare gas is caused to flow into the upper shower plate 23 via the gas introduction pipe 13 and SiH₄ gas is caused to flow into the lower shower plate 22 via a gas introduction pipe 26, a silicon (Si) film is formed on the surface of a substrate, for example, a silicon wafer 14.

In addition, if the rare gas is passed from the upper shower plate 23, and a gas of a compound containing a C atom and an F atom, in general, a fluorocarbon compound gas is passed from the lower shower plate 22, a CF membrane or film is formed. In this invention, a fluorocarbon compound gas and a gas containing an N atom (in general, at least one selected from the group consisting of N₂ gas, NF₃ gas, and NH₃ gas) are simultaneously passed from the lower shower plate 22 and, as a result, an N atom-containing fluorocarbon layer is formed. The fluorocarbon compound gas is not particularly limited, and from the viewpoint of polymerization, a gas formed of a compound represented by the formula: CₚF_{q} (where p and q satisfy the formulae: p≥4 and 1.5≤p/q≤2.0) is preferred and a gas formed of at least one compound selected from the group consisting of C₄F₆, C₄F₈, and C₅F₈) is more preferred. Hexafluorocyclobutadiene, hexafluoro-2-butyne, and the like are given as C₄F₆, octafluorocyclobutane, octafluoro-2-butene, and the like are given as C₄F₈, and octafluorocyclopentene, octafluoro-2-pentyne, octafluoro-1,4-pentadiene, octafluoro-1,3-pentadiene, octafluoro(isoprene), and the like are given as C₅F₈.

On the other hand, the rare gas is passed from the upper shower plate 23, and a gas of a compound containing a C atom and an H atom, in general, a hydrocarbon compound gas and a gas containing an Si atom (in general, Si₂H₆ gas) are passed from the lower shower plate 22, and an Si atom-containing hydrocarbon layer is formed. The hydrocarbon compound gas is not particularly limited, and from the viewpoint of polymerization, a gas formed of a unsaturated hydrocarbon represented by the formula: CₘH₂ₘ₋₂ (where m represents 4 to 6) is preferred and a gas formed of at least one compound selected from the group consisting of C₄H₆, C₅H₈, and C₆H₁₀ is more preferred. Butadiene, 2-butyne, cyclobutene, and the like are given as C₄H₆, 1,3-pentadiene, 1,4-pentadiene, isoprene, cyclopentene, 1-pentyne, 2-pentyne, and the like are given as C₅H₈, and 3-methyl-1-pentyne, 3,3-dimethyl-1-butyne, cyclohexene, and the like are given as C₆H₁₀.

Exhaust gases in a process chamber 31 pass through an exhaust duct via exhaust ports (not shown) and then are each introduced into a small pump from any one of inlet ports of the small pump.

Next, description is made about a method of manufacturing the interconnect structure illustrated in Fig. 1 which is not part of the invention as defined by the claims. In order to manufacture the illustrated structure, the hydrocarbon layer 1 containing Si atoms is at first formed as a barrier cap layer and, thereafter, the fluorocarbon layer 2 containing N atoms, and the hydrocarbon layer 3 containing Si atoms as another barrier layer are formed successively in the stated order. The successive film formation can be carried out in the plasma processing apparatus 102 illustrated in Fig. 2, with the rare gas flowing from the upper shower plate 23 and with a hydrocarbon compound gas and a gas containing Si atoms flowing from the lower shower plate 22. Thus, the hydrocarbon layer 1 containing Si atoms is formed by CVD. Then, the gas which flows through the lower shower plate 22 is switched to a mixture of a fluorocarbon compound gas and a gas containing N atoms to form the fluorocarbon layer 2 containing N atoms by CVD. Thereafter, the gas which flows through the lower shower plate 22 is switched to a hydrocarbon compound gas and a gas containing Si atoms to form the hydrocarbon layer 3 containing Si atoms by CVD.

Then, the via hole 4 which passes through the hydrocarbon layer 1 containing Si atoms and the lower part of the fluorocarbon layer 2 containing N atoms is formed and, thereafter, the groove 5 which passes through the remaining part (upper part) of the fluorocarbon layer 2 containing N atoms and the hydrocarbon layer 3 containing Si atoms is formed. As a barrier layer for preventing diffusion of the electrode metal into the interlayer insulation film, the films 8 and 9 made of a fluoride of nickel, preferably nickel (II) fluoride (expressed as NiF₂) are formed on inner walls of the via hole 4 and the groove 5, respectively, by forming nickel films by PVD and then fluorinating the films, or by directly forming the films made of the fluoride of nickel by MOCVD. The via hole 4 and the groove 5 may be formed by first forming the groove 5 and then masking the inner wall of the groove 5 at a predetermined thickness to form the via hole 4. Alternatively, the groove 5 may be formed by forming a hole having the-same inner diameter as that of the via hole 4 and then widening the upper part into the via hole 4 with an inner surface of the part of the via hole 4 being masked. After that, the via hole 4 and the groove 5 are filled with Cu to form the conductors 6 and 7. In this way, the interlayer interconnect structure 10 is completed.

Next, description is made more in detail about physical properties of a CF film containing N atoms (corresponding to the fluorocarbon layer containing N atoms) and a CH film containing Si atoms (corresponding to the hydrocarbon layers containing Si atoms) according to the exemplary embodiment of this invention.

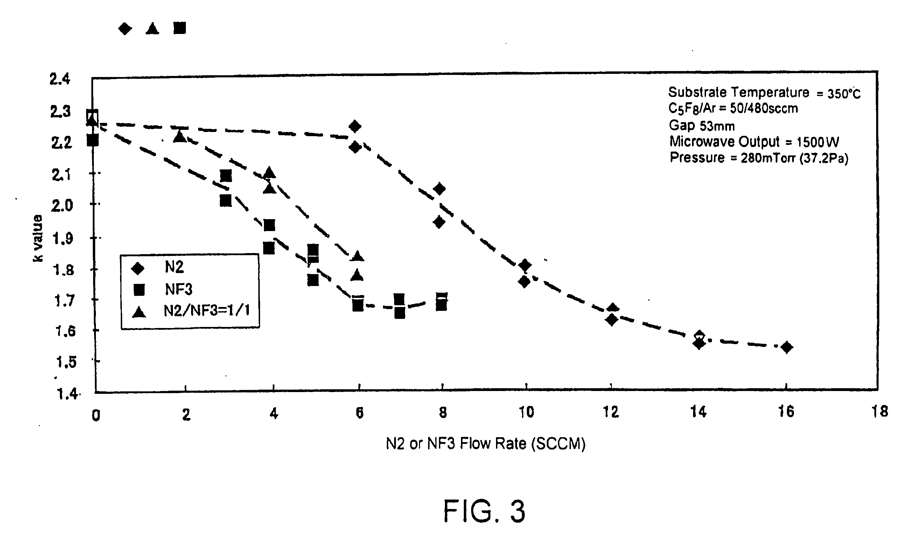

Fig. 3 is a graph illustrating change in value of the specific dielectric constant k2 by addition of N atoms in the CF film containing N atoms according to the exemplary embodiment of this invention. It is to be noted that the CF film containing N atoms illustrated in Fig. 3 to Fig. 6 is formed by CVD in the apparatus illustrated in Fig. 2 at a pressure of 280 millitorr (mTorr) (= 37.2 Pa) and at a microwave output of 1,500 W with the substrate temperature kept at 350°C, the flow rate of Ar being 480 sccm, and the flow rate of C₅F₈ (octafluorocyclopentene) being 50 sccm, by using N₂ gas, NF₃ gas, or a mixture of both of the N₂ gas and the NF₃ gas [N₂/NF₃ = 1/1 (volume ratio)] as a gas containing N atoms and changing the flow rates of the gases containing N atoms.

As illustrated in Fig. 3, it can be seen that, by causing the gas containing N atoms to flow, the value of k2 of the CF film containing N atoms is lowered from 2.2 to about 1.5. With regard to the respective gases, the NF₃ gas makes it possible to obtain a low dielectric constant (k = about 1.6) at a relatively low flow rate (6 to 8 sccm). In this case, in the CF film containing N atoms, the content of N atoms is about 0.7 atom% and the ratio of the number of the F atoms to the number of the C atoms (F/C) is about 1.04, which means the number of the F atoms is larger. The N₂ gas can not establish a low dielectric constant at such a flow rate. However, when the flow rate becomes higher and at a flow rate of 14 to 16 sccm, a very low dielectric constant can be accomplished such that k2 becomes about 1.5. In this case, in the CF film containing N atoms, the content of N atoms is about 4.3 atom% and the F/C ratio is about 0.85. The mixture of the NF₃ gas and the N₂ gas has a tendency of providing a flow rate-dielectric constant relationship which is intermediate between those of the two gases.

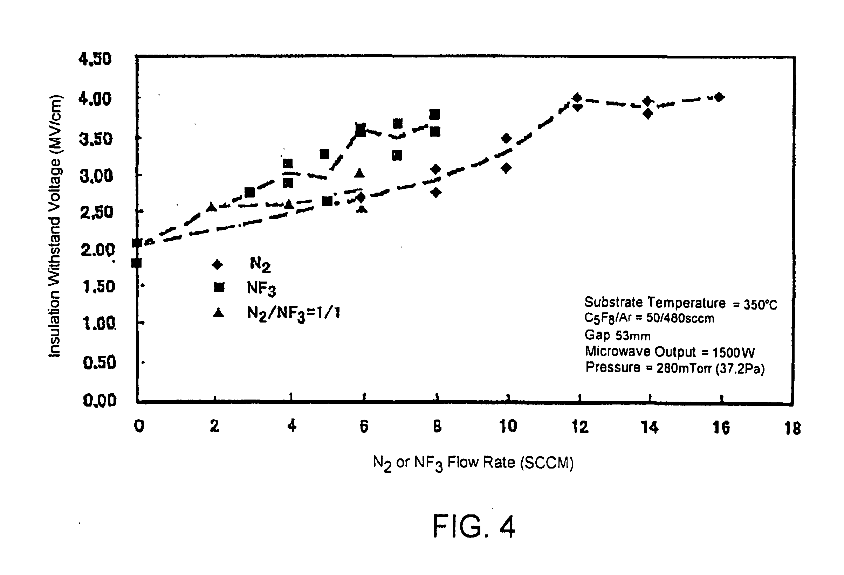

With reference to Fig. 4, it can be seen that causing the gas containing N atoms to flow is effective to roughly double the withstand voltage of the CF film containing N atoms from 2.0 MV/cm to 4.0 MV/cm. With regard to the respective gases, it can be seen that, with the NF₃ gas, a high withstand voltage (about 3.50 MV/cm) is obtained at a relatively low flow rate (6 to 8 sccm) and that, with the N₂ gas, a high withstand voltage is not obtained at such a flow rate, but, when the flow rate becomes higher, a higher withstand voltage (about 4.0 MV/cm) is obtained. The mixture of the two gases has a tendency of providing a relationship which is intermediate between those of the two gases.

The withstand voltages of the films (or layers) herein described may be measured by the mercury probe method or the like.

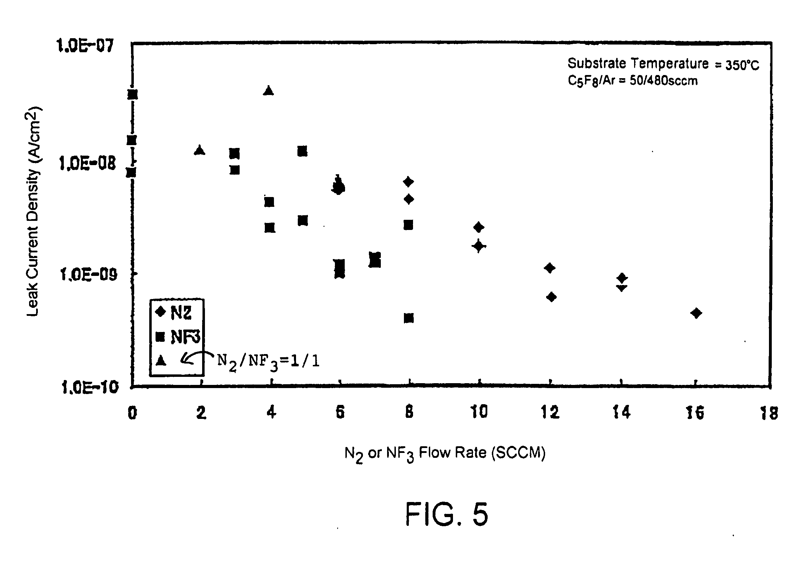

With reference to Fig. 5, it can be seen that causing the gas containing N atoms flow serves to reduce the leak current of the CF film containing N atoms. With regard to the respective gases, it can be seen that, with the NF₃ gas, a leak current is reduced at a relatively low flow rate (8 sccm) and that, with the N₂ gas, a small leak current is not obtained at such a flow rate, but, when the flow rate becomes higher, the leak current can be reduced. The mixture of the two gases, also here, has a tendency of providing a relationship which is intermediate between those of the two gases.

The leak currents of the films (or layers) herein described may be measured by the mercury probe method or the like.

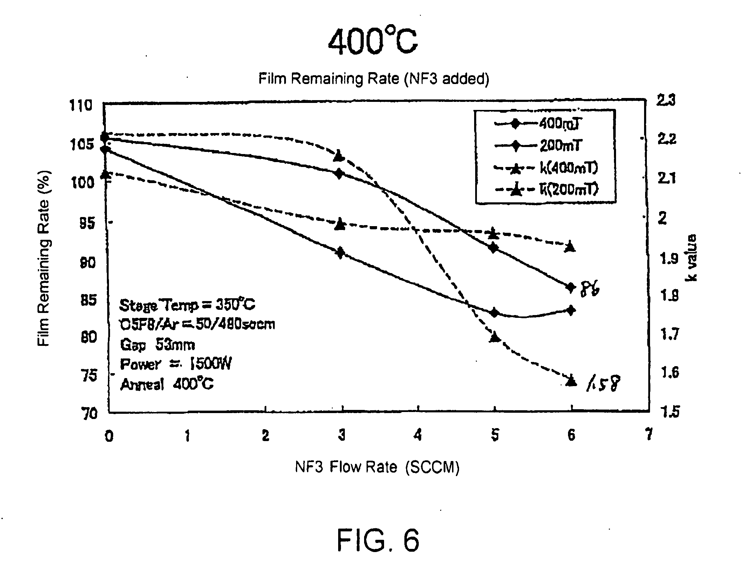

Fig. 6 illustrates change in a film remaining rate, namely, a film shrinkage rate when the CF film containing N atoms formed as described above using the NF₃ gas is annealed at 400°C. When the film is formed with the pressure in the chamber being 400 mTorr (= 53.2 Pa) and the flow rate of NF₃ being 6 sccm, the value of k2 is 1.58 and the film remaining rate is 86%.

The film shrinkage rates of the films (or layers) herein described may be determined by measuring the film thicknesses before and after the annealing.

From the above, it can be seen that, when a consumed amount of the gas containing N atoms is adjusted in relation to the fluorocarbon compound gas, the dielectric constant, the withstand voltage, the amount of the leak current, and the like of the CF film containing N atoms can be appropriately adjusted. More specifically, various characteristics of the CF film can be adjusted by using a desired fluorocarbon compound gas and a desired gas containing N atoms and by appropriately adjusting conditions with reference to the operating conditions according to Fig. 3 to Fig. 6 to form the CF film. The specific dielectric constant k2 of the CF film containing N atoms is preferably 1.5 to 2.2. In this case, the withstand voltage and the amount of the leak current of the CF film are also appropriately controlled. The CF film contains F atoms and C atoms with the F/C ratio being 0.8 to 1.1, and contains 0.5 to 6 atom% of N atoms.

In the interlayer insulation film formed by laminating the CF film(s) and the CH film(s), the CF film is formed to be relatively thick, and hence a film remaining rate may practically be small to a certain extent. On the other hand, the dielectric constant of the CH film is relatively high, and hence the CH film has to be formed as thin as possible. Therefore, it is necessary to make the film remaining rate of the CH film as high as possible, that is, it is necessary to make the shrinkage rate as small as possible. Next, physical properties of a CH film containing Si atoms according to this invention are described.

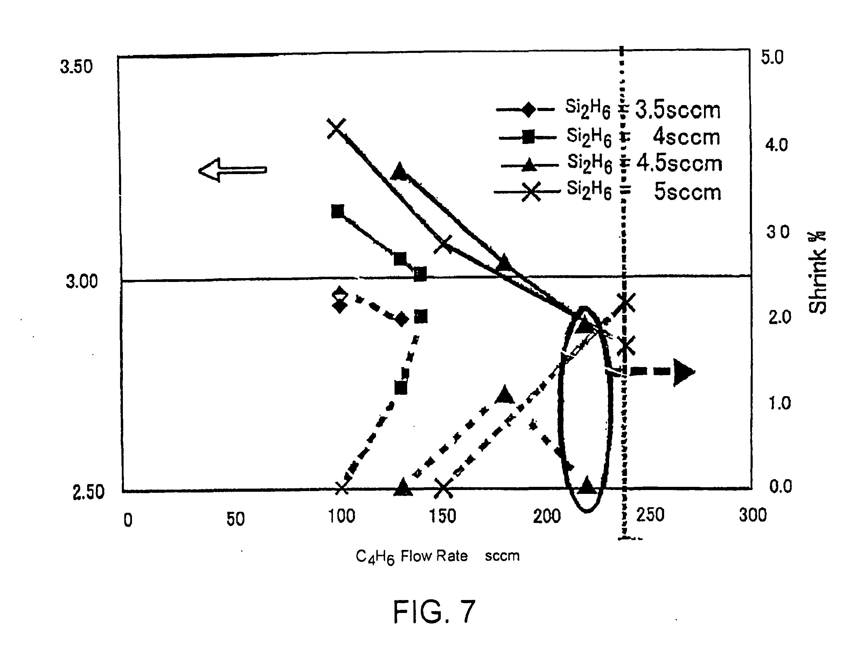

Fig. 7 is a graph illustrating change in value of the specific dielectric constant k1 and change in film shrinkage rate due to thermal annealing by addition of Si atoms in the CH film containing Si atoms as a barrier layer according to the embodiment of this invention. The CH film containing Si atoms illustrated in Fig. 7 is formed by CVD in the apparatus illustrated in Fig. 2 at a pressure of 40 mTorr (= 37.2 Pa) and at a microwave output of 3,000 W with the substrate temperature being 380°C, the flow rate of Ar being 200 sccm, and the flow rates of C₄H₆ (2-butine) gas and Si₂H₆ gas being varied to be 80 to 240 sccm and 2 to 5 sccm, respectively.

As illustrated in Fig. 7, as the flow rate of the C₄H₆ gas becomes higher, the value of k1 is more improved. On the other hand, there is a tendency that the extent of the shrinkage is more improved as the amount of the Si₂H₆ gas is larger. It is to be noted that the term "shrinkage" as used herein means {(film thickness before annealing) - (film thickness after annealing)} / (film thickness before-annealing). Actually, when the flow rate of the C₄H₆ gas was 220 sccm and the flow rate of the Si₂H₆ gas was 4.5 sccm, the obtained shrinkage rate was 0.7% and the obtained value of k1 was 2.88, which are practical values. The leak current here was 2.5xE-8 (A/cm²) (in the case of 1 MV/cm), the content of Si atoms in the film was 7 atom%, the content of C atoms was 43 atom%, the content of H atoms was 46.9 atom%, and, in addition, 2.9 atom% of O atoms were contained. The density of the film was 1.26 g/cm³ (= 1,260 kg/m³).

From the above, it can be seen that, by adjusting the amount of usage of the gas containing Si atoms in relation to the hydrocarbon compound gas, the dielectric constant, the film shrinkage rate, and the like of the CH film containing Si atoms can be appropriately adjusted. More specifically, by using a desired hydrocarbon compound gas and a desired gas containing Si atoms and appropriately adjusting conditions with reference to the operating conditions according to Fig. 7 to form the CH film, various characteristics of the CH film can be adjusted. The specific dielectric constant k1 of the CH film containing Si atoms is preferably 2.8 to 3.0. In this case, the film shrinkage rate is also appropriate. The CH film contains H atoms and C atoms with the H/C ratio being 0.8 to 1.2, and contains 2 to 10 atom% of Si atoms.

### Industrial Applicability

As described above, the interlayer insulation film according to this invention, the method of producing the same, the interconnect structure, and the method of producing the same are optimum for a semiconductor device or a wiring board including a low-dielectric-constant interlayer insulation film and an interconnect structure, or an electronic device including the semiconductor device and the wiring board.

## Claims

1. An interlayer insulation film formed by laminating a hydrocarbon layer containing 2 to 10 atom% of Si atoms and a fluorocarbon layer containing 0.5 to 6 atom% of N atoms,
wherein the hydrocarbon layer contains H atoms and C atoms with a ratio of a number of the H atoms to a number of the C atoms (H/C) being from 0.8 to 1.2 and
wherein the fluorocarbon layer contains F atoms and C atoms with a ratio of a number of the F atoms to a number of the C atoms (F/C) being from 0.8 to 1.1.

2. An interlayer insulation film according to claim 1, wherein the fluorocarbon layer containing N atoms is laminated on the hydrocarbon layer containing Si atoms.

3. An interlayer insulation film according to claim 2, wherein a hydrocarbon layer containing Si atoms is further laminated on the fluorocarbon layer containing N atoms.

4. An interlayer insulation film according to any one of claims 1 to 3, wherein each hydrocarbon layer containing Si atoms has a thickness of 10 to 50 nm.

5. An interlayer insulation film according to any one of claims 1 to 4, wherein the fluorocarbon layer containing N atoms has a thickness of 50 to 500 nm.

6. A method of manufacturing the interlayer insulation film according to any one of claims 1 to 5, wherein each hydrocarbon layer containing Si atoms is formed by CVD using at least one type of gas containing C atoms and H atoms and a gas containing Si atoms in plasma, the plasma being generated using at least one gas selected from the group consisting of Ar gas, Xe gas, and Kr gas; and wherein the fluorocarbon layer containing N atoms is formed by CVD using at least one type of gas containing C atoms and F atoms and a gas containing N atoms in plasma, the plasma being generated using at least one gas selected from the group consisting of Ar gas, Xe gas, and Kr gas.

## Patentansprüche

1. Zwischenschichtisolationsfilm, der durch Laminieren einer Kohlenwasserstoffschicht, die 2 bis 10 Atom% an Si-Atomen enthält, und einer Fluorkohlenstoffschicht, die 0,5 bis 6 Atom% an N-Atomen enthält, gebildet ist,
wobei die Kohlenwasserstoffschicht H-Atome und C-Atome mit einem Verhältnis von einer Anzahl der H-Atome zu einer Anzahl der C-Atome (H/C) von 0,8 bis 1,2 enthält, und
wobei die Fluorkohlenstoffschicht F-Atome und C-Atome mit einem Verhältnis von einer Anzahl der F-Atome zu einer Anzahl der C-Atome (F/C) von 0,8 bis 1,1 enthält.

2. Zwischenschichtisolationsfilm gemäß Anspruch 1, wobei die Fluorkohlenstoffschicht, die N-Atome enthält, außerdem auf die Kohlenwasserstoffschicht, die Si-Atome enthält, laminiert ist.

3. Zwischenschichtisolationsfilm gemäß Anspruch 2, wobei eine Kohlenwasserstoffschicht, die Si-Atome enthält, auf die Fluorkohlenstoffschicht, die N-Atome enthält, laminiert ist.

4. Zwischenschichtisolationsfilm gemäß einem der Ansprüche 1 bis 3, wobei jede Kohlenwasserstoffschicht, die Si-Atome enthält, eine Dicke von 10 bis 50 nm besitzt.

5. Zwischenschichtisolationsfilm gemäß einem der Ansprüche 1 bis 4, wobei die Fluorkohlenstoffschicht, die N-Atome enthält, eine Dicke von 50 bis 500 nm besitzt.

6. Verfahren zur Herstellung des Zwischenschichtisolationsfilms gemäß einem der Ansprüche 1 bis 5, wobei jede Kohlenwasserstoffschicht, die Si-Atome enthält, durch CVD unter Verwendung mindestens eines Typs eines Gases, das C-Atome und H-Atome enthält, und eines Gases, das Si-Atome enthält, im Plasma gebildet wird, wobei das Plasma unter Verwendung mindestens eines Gases, ausgewählt aus der Gruppe, bestehend aus Ar-Gas, Xe-Gas und Kr-Gas, erzeugt ist; wobei die Fluorkohlenstoffschicht, die N-Atome enthält, durch CVD und unter Verwendung mindestens eines Typs eines Gases, das C-Atome und F-Atome enthält, und eines Gases, das N-Atome enthält, im Plasma gebildet wird, wobei das Plasma unter Verwendung mindestens eines Gases, ausgewählt aus der Gruppe, bestehend aus Ar-Gas, Xe-Gas und Kr-Gas, erzeugt ist.

## Revendications

1. Film d'isolation intercouche formé en stratifiant une couche d'hydrocarbure contenant 2 à 10 % atomique d'atomes Si et une couche de fluorocarbone contenant 0,5 à 6 % atomique d'atomes N,
dans lequel la couche d'hydrocarbure contient des atomes H et des atomes C avec un rapport entre un nombre des atomes H et un nombre des atomes C (H/C) de 0,8 à 1,2 et
dans lequel la couche de fluorocarbone contient des atomes F et des atomes C avec un rapport entre un nombre des atomes F et un nombre des atomes C (F/C) de 0,8 à 1,1.

2. Film d'isolation intercouche selon la revendication 1, dans lequel la couche de fluorocarbone contenant des atomes N est stratifiée sur la couche d'hydrocarbure contenant des atomes Si.

3. Film d'isolation intercouche selon la revendication 2, dans lequel une couche d'hydrocarbure contenant des atomes Si est en outre stratifiée sur la couche de fluorocarbone contenant des atomes N.

4. Film d'isolation intercouche selon l'une quelconque des revendications 1 à 3, dans lequel chaque couche d'hydrocarbure contenant des atomes Si a une épaisseur de 10 à 50 nm.

5. Film d'isolation intercouche selon l'une quelconque des revendications 1 à 4, dans lequel la couche de fluorocarbone contenant des atomes N a une épaisseur de 50 à 500 nm.

6. Procédé de fabrication du film d'isolation intercouche selon l'une quelconque des revendications 1 à 5, dans lequel chaque couche d'hydrocarbure contenant des atomes Si est formée par CVD en utilisant au moins un type de gaz contenant des atomes C et des atomes H, et un gaz contenant des atomes Si dans un plasma, le plasma étant généré en utilisant au moins un gaz choisi dans le groupe consistant en le gaz Ar, le gaz Xe et le gaz Kr ; dans lequel la couche de fluorocarbone contenant des atomes N est formée par CVD et en utilisant au moins un type de gaz contenant des atomes C et des atomes F et un gaz contenant des atomes N dans un plasma, le plasma étant généré en utilisant au moins un gaz choisi dans le groupe consistant en le gaz Ar, le gaz Xe et le gaz Kr.
